Europäisches Patentamt

(19) European Patent Office  (11) Publication number: **0 084 722**

Office européen des brevets  **B1**

(12) **EUROPEAN PATENT SPECIFICATION**

(45) Date of publication of patent specification: **13.11.85**  (51) Int. Cl.⁴: **H 03 K 5/24,** G 01 R 19/165, H 03 F 3/45

(21) Application number: **82306765.7**

(22) Date of filing: **17.12.82**

(54) **Differential circuit.**

(30) Priority: **17.12.81 JP 204317/81**

(43) Date of publication of application: **03.08.83 Bulletin 83/31**

(45) Publication of the grant of the patent: **13.11.85 Bulletin 85/46**

(84) Designated Contracting States: **DE FR GB**

(56) References cited:
**DE-A-2 905 629**
**DE-A-3 119 923**
**DE-A-3 120 979**
**GB-A-1 241 432**
**US-A-3 872 323**
**US-A-4 177 394**

**Patent Abstracts of Japan, vol. 5, no. 149, 19 September 1981 & JP-A-56-83123**

(73) Proprietor: **FUJITSU LIMITED**
**1015, Kamikodanaka Nakahara-ku**
**Kawasaki-shi Kanagawa 211 (JP)**

(72) Inventor: **Sano, Yoshiaki**
**Miyamaedaira-mezon 101 3-12-24 Miyamaedaira**
**Miyamae-ku Kawasaki-shi Kanagawa 213 (JP)**
Inventor: **Omura, Isamu**
**3-12, Shinjo Nakamachi Nakahara-ku**
**Kawasaki-shi Kanagawa 211 (JP)**
Inventor: **Hiramatsu, Ryo**
**Ishikawa-so 2-3 100-44, Shinsaku**
**Takatsu-ku Kawasaki-shi Kanagawa 213 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

## Description

The present invention relates to differential circuitry for producing an output which is dependent upon the difference between two inputs.

A known kind of differential circuitry has first and second input points connected respectively to first and second transistors of a differential stage which operates in dependence upon difference of potential between the first and second input points and provides an output dependent upon the conductive state of the second transistor, which output is connected to drive a control transistor which in turn is connected to control the base current of an output stage transistor of the circuitry. An example of such circuitry is disclosed in JP—A—56—83123 (A).

More generally differential circuitry of the said known kind, such as a comparator or an operational amplifier, is designed so as to operate normally only when the variation of the input signal remains between a supply voltage level and ground potential. For example, if the supply voltage $V_{CC}$ is +5 V, a comparison is made of the two inputs in the range between 0 V and +5 V, i.e. the positive voltage range. Examples of such conventional compartaor circuits, however, cannot operate normally when an input becomes negative owing to noise or the like.

It is desirable to provide differential circuitry in which the output of the circuitry can be kept at the correct value, corresponding to the results of the comparison between the two inputs, even if one of the two inputs becomes negative.

To this end, according to the present invention, there is provided differential circuitry of the aforesaid kind, wherein an auxiliary transistor, having its base connected so as to be maintained at a constant voltage relative to ground when the circuitry is in use, is connected between the said second input point and a base of the said output stage transistor so that when the potential of the said second input point falls below a preselected normal minimum operating value the auxiliary transistor becomes conductive and thereby prevents that fall from producing an unwanted change in a circuitry output available from the said output stage transistor.

Reference will now be made, by way of example, to the accompanying drawings, in which:—

Figure 1 is a circuit diagram of a conventional comparator;

Figure 2 is a characteristic diagram of the circuitry of Figure 1;

Figure 3 is a circuit diagram of a conventional operational amplifier;

Figure 4 is a circuit diagram of a comparator embodying the present invention;

Figures 5A and 5B are circuit diagrams of two constant voltage sources which can be used in the circuitry of Figure 4; and

Figure 6 is a circuit diagram of an operational amplifier embodying the present invention.

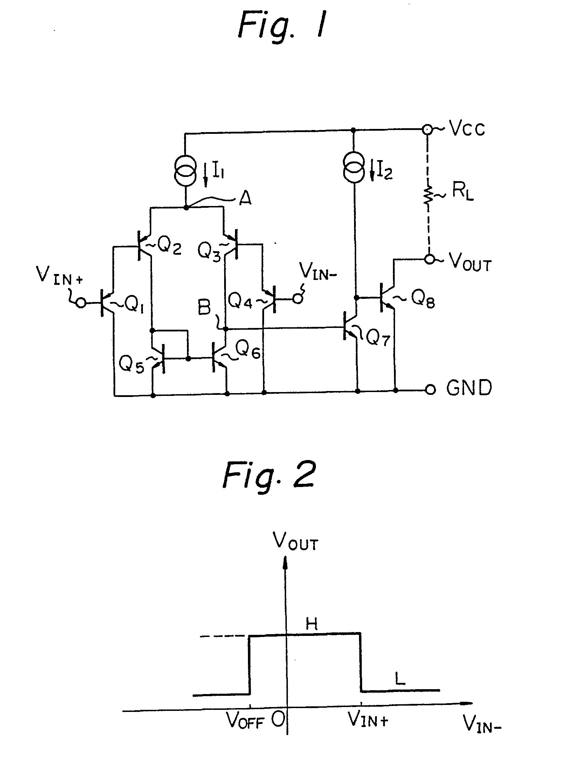

The differential circuit of Figure 1 is a prior art comparator circuit comprising transistors $Q_1$ through $Q_8$ and constant current sources $I_1$ and $I_2$. The transistors $Q_1$ through $Q_6$ form a differential stage. The transistor $Q_7$ is a control transistor driven by the output of the differential stage, and the transistor $Q_8$ is an output stage transistor of the open collector type, the base current of which is controlled by the transistor $Q_7$. A resistor $R_L$ is a load connected between a voltage supply line ($V_{CC}$) and an output point ($V_{OUT}$). In the comparator circuit of Figure 1, two input voltages $V_{IN+}$ and $V_{IN-}$ applied to respective input points of the circuitry are compared to detect which is the higher. The circuitry produces an output $V_{OUT}$ which depends upon the result of the comparison.

For example, assume that one input $V_{IN+}$ is fixed at a constant positive value $V_{IN}$ and that the other input $V_{IN-}$ is changed between the supply voltage $V_{CC}$ and ground GND. In such a case, the output $V_{OUT}$ changes as shown in Figure 2. When $V_{IN-} > V_{IN+}$, the transistors $Q_1$ and $Q_2$ are on and the transistors $Q_3$ and $Q_4$ are off, as the transistors $Q_1$ through $Q_4$ are of the pnp type. Thus the constant current $I_1$ flows through the transistor $Q_2$, and the transistors $Q_5$ and $Q_6$ become on. Since the output of the differential stage is led out from the collector of the transistor $Q_3$, no current flows to the base of the transistor $Q_7$ in the above case. Thus, the transistor $Q_7$ becomes off. Consequently, the constant current $I_2$ flows to the base of the transistor $Q_8$, the transistor $Q_8$ becomes on, and the output $V_{OUT}$ becomes L (low), as shown in Figure 2.

Conversely, when $V_{IN-} < V_{IN+}$, the transistors $Q_3$ and $Q_4$ are on and the transistors $Q_1$ and $Q_2$ are off. Thus, the constant current $I_1$ flows through the transistor $Q_3$, and the transistors $Q_5$ and $Q_6$ become off. Consequently, the current flowing through the transistor $Q_3$ flows to the base of the transistor $Q_7$ and makes the transistor $Q_7$ on. The turning on of the transistor $Q_7$ stops the current $I_2$ from flowing to the base of the transistor $Q_8$, whereupon the transistor $Q_8$ becomes off and the output $V_{OUT}$ becomes H (high).

When the input $V_{IN-}$ becomes negative owing to noise or the like, however, there is a problem. When the transistors $Q_3$ and $Q_4$ are on, the potential at the emitter of the transistor $Q_3$, i.e. the node A, becomes $V_{IN-} + 2V_{BE}$ ($V_{BE}$ is the base-emitter voltage). In this case, in order to keep the transistor $Q_7$ on, the potential at the base of the transistor $Q_7$, i.e. the node B, must be $V_{BE}$. However, when the input $V_{IN-}$ becomes negative, the potential difference between the nodes A and B is decreased, with the result that the potential at the node B cannot be maintained at $V_{BE}$ and the transistor $Q_3$ cannot be kept on. Thus, when the input $V_{IN-}$ falls below a negative voltage $V_{OFF}$, base current ceases to be supplied to the transistor $Q_7$ and the transistor $Q_7$ turns from on to off. Accordingly, the transistor $Q_8$ turns from off to on, and the output $V_{OUT}$ turns from "H" to "L". Thus, even though $V_{IN-} < V_{IN-}$, the output $V_{OUT}$ becomes "L" when the input $V_{IN}$ becomes lower than $V_{OFF}$, as shown in Figure 2. This inversion of the output $V_{OUT}$ is a change which is unwanted for the purposes of normal circuit operation.

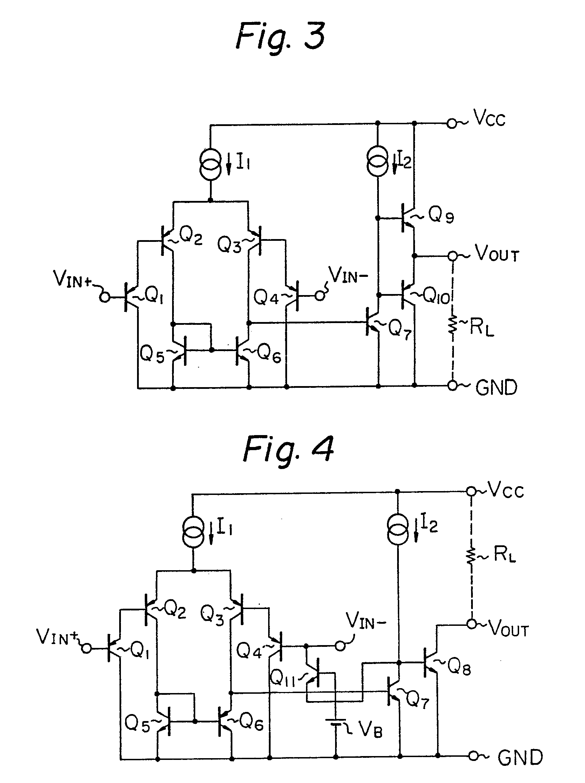

Another prior art differential circuit is shown in Figure 3. This differential circuit, an operational amplifier circuit, has the same construction as the circuit of Figure 1, except that its output stage comprises an npn transistor $Q_9$ and pnp transistor $Q_{10}$ connected in series between the voltage supply line ($V_{CC}$) and a ground point (GND) of the circuitry, and that its output $V_{OUT}$ changes linearly between $V_{CC}$ and GND. The operational amplifier circuit of Figure 3 entouners an unwanted change in the output $V_{OUT}$ similar to that described in relation to the circuit of Figure 1.

A differential circuit embodying the present invention is illustrated in Figure 4. This differential circuit, a comparator circuit, comprises differential stage transistors $Q_1$ through $Q_6$, a control transistor $Q_7$, an output stage transistor $Q_8$, and constant current sources $I_1$ and $I_2$, just like the circuit of Figure 1. The comparator circuit further comprises an auxiliary transistor $Q_{11}$ and a constant voltage source ($V_B$). The collector of the transistor $Q_{11}$, which is an npn transistor, is connected to the base of the transistor $Q_4$, and the emitter of the transistor $Q_{11}$ is connected to the collector of the transistor $Q_7$. The constant voltage source ($V_B$) is connected between the base of the transistor $Q_{11}$ and the ground GND and its voltage $V_B$ is in the range from +0.2V to +0.5V.

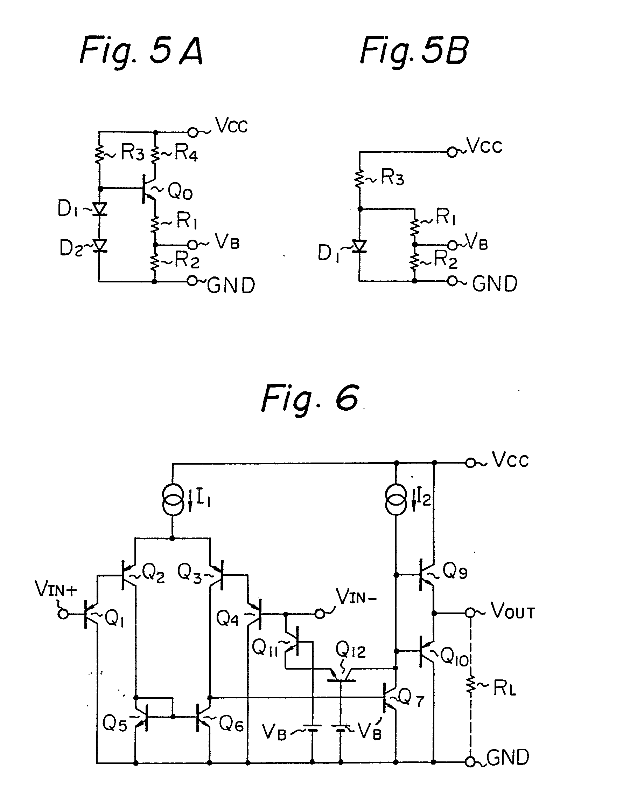

The constant voltage source ($V_B$) may be constructed as shown in Figure 5A or 5B. The circuit of Figure 5A has diodes $D_1$ and $D_2$ as constant voltage elements, an emitter-follower connected transistor $Q_0$, voltage-divider resistors $R_1$ and $R_2$, and resistors $R_3$ and $R_4$. The circuit of Figure 5B has a diode $D_1$ as a constant voltage element and voltage-divider resistors $R_1$ and $R_2$.

In the comparator circuit of Figure 4, when the input $V_{IN-}$ is in the range between 0 V and +5 V, the transistor $Q_{11}$ is off. Accordingly, the operation of the circuit of Figure 4 is exactly the same as the circuit of Figure 1. Thus, the output $V_{OUT}$ becomes "H" when the two inputs are such that $V_{IN-}<V_{IN+}$, and the output $V_{OUT}$ becomes "L" when $V_{IN-}>V_{IN+}$. When the input $V_{IN-}$ becomes negative, and the input $V_{IN+}$ is a positive value, the transistor $Q_{11}$ becomes on as a reverse direction transistor. In this case, since $V_{IN-}<V_{IN+}$, the transistors $Q_1$ and $Q_2$ are off, therefore the transistors $Q_5$ and $Q_6$ are off. However, since the input $V_{IN-}$ is negative, the transistor $Q_3$ ceases to provide base current for the transistor $Q_7$, which transistor $Q_7$ is therefore cut off as described with regard to the circuit of Figure 1. Thus, the constant current $I_2$ ceases to flow through the transistor $Q_7$, and flows instead through the transistor $Q_{11}$ to the input $V_{IN-}$. Accordingly the transistor $Q_8$ is kept off, thereby preventing the above-described unwanted change, and the output $V_{OUT}$ is kept at "H", which is the correct desired value corresponding to the input condition $V_{IN-}<V_{IN+}$.

Thus, when the potential of the input $V_{IN-}$ falls below a preselected normal minimum operating value, the auxiliary transistor $Q_{11}$ prevents that fall from producing an unwanted change in the output $V_{OUT}$.

A differential circuit according to another embodiment of the present invention is illustrated in Figure 6. This differential circuit, an operational amplifier circuit, comprises differential stage transistors $Q_1$ through $Q_6$, a control transistor $Q_7$, output stage transistors $Q_9$ and $Q_{10}$, and constant current sources $I_1$ and $I_2$, just as in the circuit of Figure 3. It further comprises an npn transistor $Q_{11}$, a npn transistor $Q_{12}$, and constant voltage sources $V_B$ and $V_B'$. In the operational amplifier circuit of Figure 6, the collector of the transistor $Q_{11}$ is connected to the base of the transistor $Q_4$, the emitter of the transistor $Q_{11}$ is connected to the emitter of the transistor $Q_{12}$, and the collector of the transistor $Q_{12}$ is connected to the collector of the transistor $Q_7$. The constant voltage source $V_B$ is connected between the base of the transistor $Q_{11}$ and the ground GND, and the constant voltage source $V_B'$ is connected between the base of the transistor $Q_{12}$ and the ground GND. The constant voltage source $V_B$ is set to a voltage in the range from +0.2 V to +0.5 V, and the constant voltage source $V_B'$ is set to a voltage of about +0.5 V.

In the operational amplifier circuit of Figure 6, when the input $V_{IN-}$ is in the range between ground GND and the supply voltage $V_{CC}$, the transistors $Q_{11}$ and $Q_{12}$ are off. Thus, the operation of the circuit of Figure 6 is exactly the same as the circuit of Figure 3. In the operational amplifier circuit of Figure 6, however, the output $V_{OUT}$ changes linearly between the supply voltage $V_{CC}$ and ground GND, and the voltage of the collector of the transistor $Q_7$ changes between the supply voltage $V_{CC}$ and ground GND. Thus, if the emitter of the transistor $Q_{11}$ were connected directly to the collector of the transistor $Q_7$, the transistor $Q_{11}$ might break down because of the low breakdown voltage of the backward emitter-based voltage. The additional transistor $Q_{12}$ is inserted between the emitter of the transistor $Q_{11}$ and the collector of the transistor $Q_7$ in order to prevent such breakdown of the transistor $Q_{11}$. When the input $V_{IN-}$, i.e. the voltage at the base of the transistor $Q_4$, becomes negative, the transistor $Q_7$ becomes off but the reverse direction transistor $Q_{11}$ and the transistor $Q_{12}$ become on and the current $I_2$ flows through the transistors $Q_{11}$ and $Q_{12}$ to the input $V_{IN-}$. As described above, therefore, output error owing to abnormal input can be prevented.

Accordingly an embodiment of the present invention can provide differential circuitry producing an output dependent upon the difference between two inputs, in which an unwanted change in output, owing to abnormal input, can be prevented. Further, in the embodiment as described with reference to figures 4 and 6, when a negative surge voltage is applied to the input $V_{IN-}$, the voltage of the input $V_{IN-}$ can be clamped by the current $I_2$ flowing through the transistor $Q_{11}$, so that damage of the internal circuit can be prevented. Further, when the voltage supply is turned on, the rise of the voltage of the input $V_{IN-}$ can be speeded up by the current $I_2$ flowing through the transistor $Q_{11}$.

**Claims**

1. Differential circuitry having first and second input points connected respectively to first and second transistors ($Q_2$, $Q_4$) of a differential stage which operates in dependence upon difference of potential between the first and second input points and provides an output dependent upon the conductive state of the second transistor, which output is connected to drive a control transistor ($Q_7$) which in turn is connected to control the base current of an output stage transistor ($Q_8$, $Q_{10}$) of the circuitry; characterised in that an auxiliary transistor ($Q_{11}$), having its base connected so as to be maintained at a constant voltage ($V_B$) relative to ground when the circuitry is in use, is connected between the said second input point and a base of the said output stage transistor so that when the potential of the said second input point falls below a preselected normal minimum operating value the auxiliary transistor ($Q_{11}$) becomes conductive and thereby prevents that fall from producing an unwanted change in a circuitry output ($V_{OUT}$) available from the said output stage transistor.

2. Circuitry as claimed in claim 1, wherein the said output stage transistor ($Q_8$) is an npn transistor and the said auxiliary transistor ($Q_{11}$) is an npn transistor having a collector connected to the said second transistor ($Q_4$) and having an emitter connected to a base of the said output stage transistor.

3. Circuitry as claimed in claim 1, wherein the said output stage transistor is a pnp transistor ($Q_{10}$) connected, in series with a further transistor ($Q_9$) of the output stage, between a voltage supply line of the circuitry and a ground point thereof, the said further transistor ($Q_9$) being an npn transistor, and the said auxiliary transistor is an npn transistor ($Q_{11}$) having a collector connected to the said second transistor ($Q_4$) and having an emitter connected to an emitter of an additional npn transistor ($Q_{12}$) which has a collector connected to a collector of the said control transistor ($Q_7$) and which has its base connected so as to be maintained at a constant voltage ($V_B'$) relative to ground when the circuitry is in use.

**Patentansprüche**

1. Differenzschaltungsanordnung mit ersten und zweiten Eingangspunkten, die mit einem ersten bzw. einem zweiten Transistoren ($Q_1$, $Q_4$) einer Differenzstufe verbunden sind, welche in Abhängigkeit von der Differenz des Potentials zwischen dem ersten und zweiten Eingangspunkt arbeitet und einen Ausgang erzeugt, der von dem Leitfähigkeitszustand des zweiten Transistors abhängt, wobei der Ausgang angeschlossen ist, einen Steuertransistor ($Q_7$) zu treiben, der wiederum zur Steuerung des Basisstroms eines Ausgangstransistors ($Q_8$, $Q_{10}$) der Schaltungsanordnung angeschlossen ist, dadurch gekennzeichnet, daß ein Hilfstransistor ($Q_{11}$), dessen Basis so angeschlossen ist, daß sie relativ zu Erde bei einer konstanten Spannung ($V_B$) gehalten wird, wenn die Schaltung in Betrieb ist, zwischen dem genannten zweiten Eingangspunkt und einer Basis des genannten Ausgangsstufentransistors so angeschlossen ist, daß dann, wenn das Potential des genannten zweiten Eingangsspunktes unter einen vorbestimmten, normalen, minimalen Arbeitswert fällt, der Hilfstransistor ($Q_{11}$) leitend wird und dadurch verhindert, daß der Abfall eine ungewollte Änderung des Schaltungsanordnungsausgang ($V_{OUT}$), der an dem genannten Ausgangsstufentransistor verfügbar ist, erzeugt.

2. Schaltungsanordnung nach Anspruch 1, bei welcher der genannte Ausgangsstufentransistor ($Q_8$) ein npn-Transistor ist und der genannte Hilfstransistor ($Q_{11}$) ein npn-Transistor ist, mit einem Kollektor, der mit dem genannten zweiten Transistor ($Q_4$) verbunden ist, und einem Emitter, der mit einer Basis des genannten Ausgangsstufentransistors verbunden ist.

3. Schaltungsanordnung nach Anspruch 1, bei welcher der genannte Ausgangsstufentransistor ein pnp-Transistor ($Q_{10}$) ist, der, in Reihe mit einem weiteren Transistor ($Q_9$) der Ausgangsstufe, zwischen einer Spannungsversorgungsleitung der Schaltungsanordnung und einem Erdepunkt derselben angeschlossen ist, wobei der weitere Transistor ($Q_9$) ein npn-Transistor ist und der genannte Hilfstransistor ein npn-Transistor ($Q_{11}$) ist, der einen Kollektor hat, der mit dem genannten zweiten Transistor ($Q_4$) verbunden ist, und der einen Emitter hat, der mit einem Emitter eines zusätzlichen npn-Transistors ($Q_{12}$) verbunden ist, der einen Kollektor hat, der mit einem Kollektor des genannten Steuertransistors ($Q_7$) verbunden ist, und der eine Basis hat, die so angeschlossen ist, daß sie dann, wenn die Schaltungsanordnung in Betrieb ist, bei einer konstanten Spannung ($V_B'$) relativ zu Erde gehalten wird.

**Revendications**

1. Montage à différence possédant un premier et un second point d'entrée, reliés respectivement à un premier ($Q_1$) et un second transistor ($Q_4$) d'un étage différenciateur qui opère en fonction de la différence de potentiel entre les premier et second points d'entrée et délivre un signal de sortie en fonction de l'état du conduction du second transistor, le signal de sortie étant utilisé pour attaquer un transistor de commande ($Q_7$) qui est connecté pour commander le courant de base d'un transistor d'étage de sortie ($Q_8$, $Q_{10}$) du montage, caractérisé en ce qu'un transistor auxiliaire ($Q_{11}$), dont la base est connectée pour être maintenue à une tension constante ($V_B$) par rapport à la masse lorsque le montage est en service, est connecté entre le second point d'entrée et la base du transistor d'étage de sortie, de manière que lorsque le potentiel du second oint d'entrée tombe au-dessous d'une valeur minimale présélectionnée de fonctionnement normal, le transistor auxiliaire ($Q_{11}$) devienne conducteur et empêche ainsi qui la chute de potentiel ne provoque un changement indésiré dans le signal de sortie du montage ($V_{OUT}$) délivré par le transistor d'étage de sortie.

2. Montage selon la revendication 1, où le transistor d'étage de sortie ($Q_8$) est un transistor npn et le transistor auxiliaire ($Q_{11}$) est un transistor npn qui est relié par son collecteur uu second transistor ($Q_4$) et par son émetteur à la base du transistor d'étage de sortie.

3. Montage selon la revendication 1, où le transistor d'étage de sortie est un transistor pnp ($Q_{10}$) qui est branché, en série avec un autre transistor ($Q_9$) de l'étage de sortie, entre une ligne d'alimentation en tension du montage et un point de ce montage relié à la masse, cet autre transistor ($Q_9$) étant un transistor npn et ledit transistor auxiliaire étant un transistor npn ($Q_{11}$) qui est relié par son collecteur audit second transistor ($Q_4$) et par son émetteur à un émetteur d'un transistor npn supplémentaire ($Q_{12}$) qui est relié par son collecteur au collecteur dudit transistor de commande ($Q_7$) et dont la base est connectée pour être maintenue à une tension constante ($V_B'$) par rapport à la masse lorsque le montage est en service.

# Fig. 1

# Fig. 2

## Fig. 3

## Fig. 4

# Fig. 5A

# Fig. 5B

# Fig. 6